(19) Europäisches Patentamt / European Patent Office / Office européen des brevets

(11) **EP 4 266 065 B1**

(12) **FASCICULE DE BREVET EUROPEEN**

(45) Date de publication et mention de la délivrance du brevet:
**10.07.2024   Bulletin 2024/28**

(21) Numéro de dépôt: **23162473.5**

(22) Date de dépôt: **16.03.2023**

(51) Classification Internationale des Brevets (IPC):
**G01R 22/06** (2006.01)

(52) Classification Coopérative des Brevets (CPC):
**G01R 22/066**

(54) **COMPTEUR ELECTRIQUE AGENCE POUR DETECTER UNE OUVERTURE FRAUDULEUSE**

STROMZÄHLER ZUR ERKENNUNG EINER BETRÜGERISCHEN ÖFFNUNG

ELECTRIC METER DESIGNED TO DETECT A FRAUDULENT OPENING

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité:  **24.03.2022   FR 2202631**

(43) Date de publication de la demande:
**25.10.2023   Bulletin 2023/43**

(73) Titulaire: **Sagemcom Energy & Telecom SAS 92270 Bois-Colombes (FR)**

(72) Inventeurs:
- **TEBOULLE, Henri**
  **92500 RUEIL MALMAISON (FR)**
- **GRINCOURT, Christophe**
  **92500 RUEIL MALMAISON (FR)**

(74) Mandataire: **Cabinet Boettcher**
  **5, rue de Vienne**
  **75008 Paris (FR)**

(56) Documents cités:
EP-A1- 2 503 343   CN-B- 104 237 587
CN-U- 202 119 820   US-A1- 2005 039 040
US-A1- 2013 119 974   US-A1- 2021 305 829

**Description**

L'invention concerne le domaine des compteurs électriques communicants.

ARRIERE PLAN DE L'INVENTION

Un compteur électrique comporte très classiquement un boîtier comprenant un couvre-borne et un capot. Le couvre-borne et le capot sont normalement fermés en opération, lorsque le compteur est installé chez le client. Ils peuvent être ouverts exceptionnellement mais, normalement, uniquement par un opérateur travaillant pour le distributeur d'énergie.

Or, il est possible qu'un individu malintentionné tente de frauder en ouvrant le boîtier du compteur et en câblant son installation en amont du compteur, c'est-à-dire côté réseau, pour que sa consommation électrique ne soit pas comptabilisée par le compteur.

Le capot est scellé au reste du boîtier en usine, à la fin de l'assemblage du compteur, typiquement par bouterollage. De même, suite à l'installation et au raccordement du compteur, le couvre-borne est scellé au reste du boîtier. Le scellement permet à un opérateur, présent ultérieurement devant le compteur, de détecter une ouverture frauduleuse du couvre-borne ou du capot.

Il est cependant bien sûr avantageux de faire en sorte que le compteur soit capable de détecter automatiquement l'ouverture du couvre-borne et/ou du capot, c'est-à-dire sans que cette détection ne nécessite la présence d'un opérateur. Le compteur envoie alors un message d'alarme au SI (pour *Système d'Information*) du distributeur d'énergie électrique et, si l'ouverture n'était pas prévue, le distributeur peut agir contre cette manoeuvre frauduleuse.

Lorsque le compteur est sous tension (c'est-à-dire lorsque le compteur est alimenté électriquement), la détection automatique est relativement simple à mettre en oeuvre.

Par contre, lorsque le compteur est hors tension, la détection est plus complexe à réaliser car il convient de gérer l'alimentation électrique du dispositif de détection intégré dans le compteur.

On connaît un dispositif de détection de l'art antérieur, dans lequel le couvre-borne et le capot sont chacun associés à un interrupteur. L'état ouvert ou fermé des interrupteurs dépend de la présence ou non du couvre-borne et du capot. Le compteur comprend une pile qui, lorsque le compteur est hors tension, continue à alimenter la partie RTC (*Real Time Clock*) d'un microcontrôleur. Le microcontrôleur surveille en temps réel l'état des interrupteurs pour détecter une ouverture du couvre-borne et/ou du capot.

Cette solution nécessite de maintenir des fonctions du microcontrôleur actives durant toute la période hors tension, et requiert donc une pile capable de fournir une réserve d'énergie importante. Le coût de la pile est donc élevé. Par ailleurs, certains clients refusent d'utiliser des piles dans les compteurs électriques.

Il a donc été envisagé de remplacer la pile par un supercondensateur de forte valeur (1F typiquement) afin d'être capable de maintenir ces fonctions actives hors tension, typiquement pendant une durée de 5 à 7 jours. Cependant, le supercondensateur présente lui-aussi un coût significatif, qui est lié à nouveau à la forte valeur de capacité exigée pour l'application.

Dans les deux cas (pile et supercondensateur), l'autonomie de la fonction de détection est peu importante, et le compteur n'est plus capable de détecter l'ouverture du couvre-borne et/ou du capot après quelques jours de mise hors tension.

Les documents CN202119820U, US2021/305829A1 et US2013/119974A1 divulguent des compteurs utilisant des systèmes pour détecter la fraude et incorporant des super-condensateurs.

OBJET DE L'INVENTION

L'invention a pour objet de détecter l'ouverture frauduleuse d'un élément de boîtier d'un compteur survenant lorsque le compteur est hors tension, la détection étant réalisée de manière simple et peu coûteuse, sans utiliser de pile, et étant toujours efficace même après une longue période hors tension du compteur.

L'invention comporte un compteur électrique selon la revendication 1, un procédé selon la revendication 6 ainsi qu'un programme d'ordinateur selon la revendication 9.

RESUME DE L'INVENTION

En vue de la réalisation de ce but, on propose un compteur électrique comportant :

- un boîtier comprenant au moins un élément de boîtier, qui est normalement fermé en opération mais qui est susceptible d'être ouvert ;
- un supercondensateur ;

- un circuit d'alimentation agencé pour, suite à une première mise sous tension du compteur électrique, charger le supercondensateur ;
- un circuit de maintien agencé pour, suite à une mise hors tension du compteur électrique qui survient après ladite première mise sous tension, éviter que le supercondensateur ne se décharge tant que l'élément de boîtier demeure fermé ;
- un circuit de décharge agencé pour, suite à ladite mise hors tension du compteur électrique, décharger le supercondensateur si l'élément de boîtier est ouvert ;
- un circuit de traitement agencé pour, suite à une deuxième mise sous tension du compteur électrique qui survient après ladite mise hors tension, acquérir un signal de détection représentatif d'une tension aux bornes du supercondensateur et donc d'un niveau de charge du supercondensateur, et détecter, si le supercondensateur est déchargé, que l'élément de boîtier a été ouvert suite à ladite mise hors tension du compteur électrique.

Le circuit d'alimentation charge donc le supercondensateur lorsque le compteur est sous tension.

Puis, suite à une mise hors tension du compteur, le supercondensateur est déchargé rapidement par le circuit de décharge si l'élément de boîtier est ouvert. Par contre, et grâce au circuit de maintien, si l'élément de boîtier demeure fermé, le supercondensateur ne se décharge que très lentement, en fonction de ses caractéristiques intrinsèques de courant de fuite.

La fonction de détection ne nécessite pas de pile. Comme le supercondensateur n'alimente aucun composant (ni un microcontrôleur, ni un système tiers de mémorisation d'événement quelconque), et comme il n'y a aucun chemin de décharge autre que celui provoqué volontairement par l'ouverture de l'élément de boîter, la fonction de détection est opérationnelle même après une très longue période hors tension du compteur (jusqu'à plusieurs mois). Le supercondensateur peut être sous-dimensionné par rapport aux solutions de l'état de l'art, et la mise en oeuvre de l'invention est donc peu coûteuse.

On propose de plus un compteur électrique tel que précédemment décrit, dans lequel le circuit de décharge comprend au moins un interrupteur monté en parallèle avec le supercondensateur, l'interrupteur étant agencé pour coopérer avec l'élément de boîtier de sorte que, lorsque l'élément de boîtier est fermé, l'interrupteur est ouvert et de sorte que, lorsque l'élément de boîtier est ouvert, l'interrupteur est fermé et provoque une décharge du supercon-sateur.

On propose de plus un compteur électrique tel que précédemment décrit, dans lequel le compteur électrique comporte deux éléments de boîtier qui comprennent un couvre-borne et un capot, le circuit de décharge comprenant un premier interrupteur agencé pour coopérer avec le couvre-borne et un deuxième interrupteur agencé pour coopérer avec le capot, le premier interrupteur et le deuxième interrupteur étant tous deux montés en parallèle l'un avec l'autre et avec le supercondensateur.

On propose de plus un compteur électrique tel que précédemment décrit, dans lequel le circuit de traitement est relié au circuit de maintien, dans lequel le circuit de maintien est relié à une borne du supercondensateur et présente un état bloqué lorsque le compteur électrique est hors tension et un état passant lorsque le compteur électrique est sous tension, le circuit de traitement et le circuit de maintien étant agencés de sorte que, lorsque le compteur électrique est sous tension, la tension aux bornes du supercondensateur est appliquée sur une entrée du circuit de traitement via le circuit de maintien lorsque le supercondensateur est chargé, et une tension de 0V est appliquée sur ladite entrée lorsque ledit supercondensateur est déchargé.

On propose de plus un compteur électrique tel que précédemment décrit, dans lequel le circuit de maintien comporte deux premiers transistors et un deuxième transistor, les deux premiers transistors étant montés tête-bêche, l'un des premiers transistors ayant une borne reliée à ladite borne du supercondensateur et l'autre des premiers transistors ayant une borne reliée à l'entrée du circuit de traitement, le deuxième transistor étant agencé pour mettre les premiers transistors dans un état passant lorsque le compteur électrique est sous tension et que le supercondensateur est chargé.

On propose de plus un compteur électrique tel que précédemment décrit, dans lequel les premiers transistors sont des transistors de type MOSFET canal P et le deuxième transistor est un transistor de type MOSFET canal N, une grille du deuxième transistor étant reliée au circuit d'alimentation, une source du deuxième transistor étant reliée à une masse électrique, et un drain du deuxième transistor étant relié aux grilles des premiers transistors.

On propose de plus un procédé de détection, mis en oeuvre dans le circuit de traitement d'un compteur électrique tel que précédemment décrit, et comportant une phase de détection comprenant les étapes, suite à la deuxième mise sous tension du compteur électrique qui survient après ladite mise hors tension, d'acquérir le signal de détection représentatif de la tension aux bornes du supercondensateur et donc d'un niveau de charge du supercondensateur, et de détecter, si le supercondensateur est déchargé, que l'élément de boîtier a été ouvert suite à ladite mise hors tension du compteur électrique.

On propose de plus un procédé de détection tel que précédemment décrit, dans lequel un sémaphore est défini par un programme informatique implémenté dans le circuit de traitement, le sémaphore ayant, à l'issue de la fabrication du compteur électrique, une première valeur prédéfinie, le procédé de détection comprenant en outre les étapes, mises en oeuvre à chaque mise sous tension du compteur électrique, de :

- lire une valeur du sémaphore, et :
- si la valeur du sémaphore est égale à la première valeur prédéfinie, attendre une durée prédéfinie, puis conférer au sémaphore, de manière définitive, une deuxième valeur prédéfinie ;
- si la valeur du sémaphore est égale à la deuxième valeur prédéfinie, mettre en oeuvre la phase de détection.

On propose de plus un procédé de détection tel que précédemment décrit, comprenant en outre les étapes, si le circuit de traitement a détecté que l'élément de boîtier été ouvert suite à la mise hors tension du compteur électrique, de générer et d'envoyer un message d'alarme.

On propose de plus un programme d'ordinateur comprenant des instructions qui conduisent le circuit de traitement du compteur électrique tel que précédemment décrit à exécuter les étapes du procédé de détection tel que précédemment décrit.

On propose de plus un support d'enregistrement lisible par ordinateur, sur lequel est enregistré le programme d'ordinateur tel que précédemment décrit.

L'invention sera mieux comprise à la lumière de la description qui suit d'un mode de mise en oeuvre particulier non limitatif de l'invention.

## BREVE DESCRIPTION DES DESSINS

Il sera fait référence aux dessins annexés parmi lesquels :

[Fig. 1] la figure 1 représente un compteur électrique selon l'invention ;
[Fig. 2] la figure 2 représente des étapes d'un procédé de détection mis en oeuvre par le compteur.

## DESCRIPTION DETAILLEE DE L'INVENTION

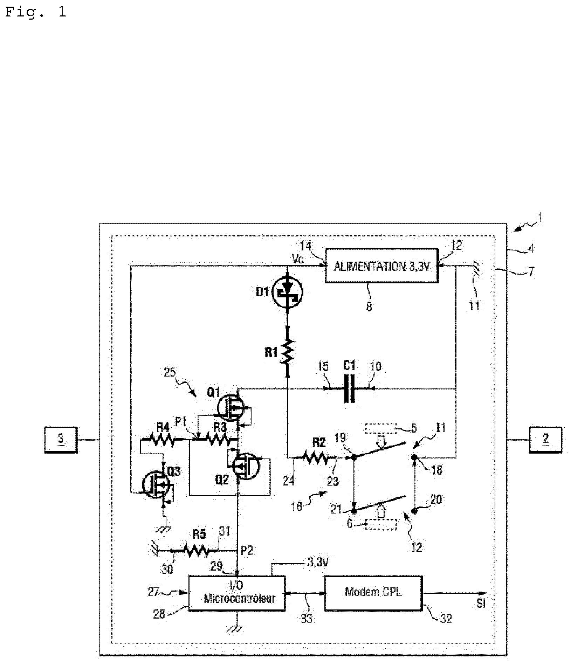

En référence à la figure 1, le compteur électrique 1 selon l'invention est destiné à mesurer l'énergie électrique fournie à l'installation électrique 2 d'un abonné par un réseau de distribution 3.

Le compteur 1 est un compteur monophasé ou polyphasé, par exemple triphasé.

Le compteur 1 comprend un boîtier 4 à l'intérieur duquel sont intégrés tous les composants fonctionnels du compteur 1. Par « boîtier », on entend donc ici l'enveloppe physique qui sépare l'intérieur du compteur 1 de l'extérieur.

Le boîtier 4 comprend au moins un élément de boîtier qui est normalement fermé en opération mais qui est susceptible d'être ouvert. L'élément de boîtier est possiblement amovible mais peut aussi demeurer solidaire du reste du boîtier 4 lorsqu'il est ouvert.

Ici, le boîtier 4 comporte deux éléments de boîtier, en l'occurrence un couvre-borne 5 et un capot 6, qui sont amovibles.

Le compteur 1 comporte un dispositif de détection 7 qui permet de détecter l'ouverture du couvre-borne 5 et/ou du capot 6 lorsque le compteur 1 est hors tension, et ce, même après une longue période hors tension du compteur 1 (typiquement 3 mois ou plus). Le dispositif de détection 7 permet donc de tracer les tentatives de fraude et d'alerter le SI si tel est le cas afin que l'opérateur puisse prendre ses dispositions quant à la fraude avérée.

Le dispositif de détection 7 comprend tout d'abord un supercondensateur C1 et un circuit d'alimentation. Le circuit d'alimentation comprend un composant d'alimentation 8 monté en parallèle du supercondensateur C1.

Le supercondensateur C1 comprend une première borne 10 reliée à une masse électrique 11 du compteur 1. Le composant d'alimentation 8 comprend un port 12 relié à la masse électrique 11. Le composant d'alimentation 8 comprend aussi une sortie 14 reliée à une deuxième borne 15 du supercondensateur C1 via une diode Schottky D1 et une résistance R1. Le composant d'alimentation 8 est alimenté uniquement lorsque le compteur 1 est sous tension, et produit dans ce cas une tension continue $V_c$ ici égale à 3,3V sur sa sortie 14.

Ainsi, le composant d'alimentation 8, lorsqu'il est lui-même alimenté, charge le supercondensateur C1.

Le dispositif de détection 7 comporte aussi un circuit de décharge 16 agencé pour, lorsque le compteur 1 est hors tension, décharger le supercondensateur C1 si le couvre-borne 5 est ouvert, ou si le capot 6 est ouvert, ou si les deux sont ouverts.

Le circuit de décharge 16 comprend au moins un interrupteur monté en parallèle avec le supercondensateur C1, l'interrupteur étant agencé pour coopérer avec l'élément de boîtier de sorte que, lorsque l'élément de boîtier est fermé, l'interrupteur est ouvert et de sorte que, lorsque l'élément de boîtier est ouvert, l'interrupteur est fermé et provoque la décharge du supercondensateur C1. Ici, il y a deux éléments de boîtier, et le circuit de décharge 16 comprend un premier interrupteur I1 agencé pour coopérer avec le couvre-borne 5 et un deuxième interrupteur I2 associé pour coopérer avec le capot 6, le premier interrupteur I1 et le deuxième interrupteur I2 étant tous deux montés en parallèle l'un avec l'autre et avec le supercondensateur C1.

Le premier interrupteur I1 a une première borne 18 et une deuxième borne 19. Le deuxième interrupteur I2 a une première borne 20 et une deuxième borne 21. Les premières bornes 18, 20 sont reliées entre elles et à la masse électrique 11. Les deuxièmes bornes 19, 21 sont reliées entre elles et à la première borne 23 d'une résistance R2, dont la deuxième borne 24 est reliée à la deuxième borne 15 du supercondensateur C1.

Le premier interrupteur I1 coopère avec le couvre-borne 5 de la manière suivante. Le premier interrupteur I1 est un interrupteur qui est, de par sa propre conception, « normalement fermé ». Un picot, solidaire du couvre-borne 5, appuie sur le premier interrupteur I1 lorsque le couvre-borne 5 est fermé et donc monté sur le boîtier 4 du compteur 1, et ouvre ainsi le premier interrupteur I1. Le premier interrupteur I1 est donc à l'état ouvert lorsque le compteur 1 se trouve dans les conditions normales de fonctionnement en opération (couvre-borne 5 fermé). Par contre, lorsque le couvre-borne 5 est ouvert, le picot n'est plus positionné en face du premier interrupteur I1 qui passe alors à l'état fermé (passant).

Le deuxième interrupteur I2 coopère avec le capot 6 de la même manière.

Lorsque le couvre-borne 5 est ouvert, le premier interrupteur I1 est fermé, ce qui provoque la décharge du supercondensateur C1. De même, lorsque le capot 6 est ouvert, le deuxième interrupteur I2 est fermé, ce qui provoque la décharge du supercondensateur C1.

Le dispositif de détection 7 comprend aussi un circuit de maintien 25 agencé pour, suite à une mise hors tension du compteur 1, éviter que le supercondensateur C1 ne se décharge tant que le couvre-borne 5 et le capot 6 demeurent fermés, c'est-à-dire tant que le premier interrupteur I1 et le deuxième interrupteur I2 demeurent à l'état ouvert.

Le circuit de maintien 25 est relié à la deuxième borne 15 du supercondensateur C1 et présente un état bloqué lorsque le compteur 1 est hors tension ou lorsque le compteur 1 est sous tension et que le supercondensateur C1 est déchargé, et un état passant lorsque le compteur 1 est sous tension et que le supercondensateur C1 est chargé.

Le circuit de maintien 25 comporte deux premiers transistors Q1, Q2, un deuxième transistor Q3, une résistance R3 et une résistance R4.

Les deux premiers transistors sont des transistors de type MOSFET canal P et sont montés tête-bêche : ils sont donc montés en série, la source du premier transistor Q1 étant reliée à la source du premier transistor Q2. Les grilles des premiers transistors Q1, Q2 sont reliées entre elles en un point P1, qui est lui-même relié aux sources des premiers transistors Q1, Q2 via la résistance R3. La résistance R3 est par exemple égale à 10kΩ.

Le drain du premier transistor Q1 est relié à la deuxième borne 15 du supercondensateur C1.

Le deuxième transistor Q3 est un transistor de type MOSFET canal N, dont la grille est reliée à la sortie 14 du composant d'alimentation 8, la source est reliée à la masse électrique 11, et le drain est relié via la résistance R4 au point P1 (et donc aux grilles des premiers transistors Q1, Q2). La résistance R4 est par exemple égale à 1kΩ.

Le circuit de maintien 25 comprend aussi la diode Schottky D1 précédemment évoquée.

Le dispositif de détection 7 comprend de plus un circuit de traitement 27 qui est relié au circuit de maintien 25. Le circuit de traitement 27 comprend un composant de traitement, qui est par exemple un processeur « généraliste », un processeur spécialisé dans le traitement du signal (ou DSP, pour *Digital Signal Processor*), un microcontrôleur, ou bien un circuit logique programmable tel qu'un FPGA (pour *Field Programmable Gate Arrays*) ou un ASIC (pour *Application Spécifie Integrated Circuit).* Le circuit de traitement 27 comprend aussi une ou des mémoires, reliées à ou intégrées dans le composant de traitement. Au moins l'une de ces mémoires forme un support d'enregistrement lisible par ordinateur, sur lequel est enregistré un programme d'ordinateur comprenant des instructions qui conduisent le composant de traitement à exécuter au moins certaines des étapes du procédé de détection qui sera décrit plus bas.

Ici, le compteur 1 présente une architecture à deux microcontrôleurs : un microcontrôleur métrologie appartenant à une partie métrologie du compteur 1, et un microcontrôleur applicatif appartenant à une partie applicative du compteur 1.

Le composant de traitement est ici le microcontrôleur applicatif 28.

Le microcontrôleur 28 est alimenté par le composant d'alimentation 8 en 3,3V et est relié à la masse électrique 11.

Le microcontrôleur 28 comprend une entrée 29 reliée au drain du premier transistor Q2. L'entrée 29 est une I/O configurée en mode I (Input).

Une résistance R5 est montée de manière à avoir une première borne 30 reliée à la masse électrique 11 et une deuxième borne 31 reliée à un point P2, qui est lui-même relié au drain du premier transistor Q2 et à l'entrée 29 du microcontrôleur 28. Ceci permet, lorsque le compteur 1 est sous tension et que le supercondensateur C1 est déchargé, de présenter une tension de 0V à l'entrée 29 du microcontrôleur 28.

Le compteur 1 comporte de plus un module de communication, qui est en l'occurrence un modem CPL 32 (CPL pour *Courant Porteur en Ligne).* Le modem CPL 32 utilise le standard CPL G3, mais un autre type de standard pourrait être utilisé, par exemple le CPL Prime.

Le microcontrôleur 28 et le modem CPL 32 sont reliés par une liaison série 33 qui utilise ici le protocole UART. Un autre type de lien pourrait bien sûr être utilisé, par exemple une liaison série SPI.

On décrit maintenant plus en détail le fonctionnement du dispositif de détection 7 du compteur 1.

A chaque mise sous tension du compteur 1, le composant d'alimentation 8 est lui-même mis sous tension et charge le supercondensateur C1. La tension maximale Umax aux bornes du supercondensateur C1 est égale à 3,3V (c'est-à-dire à Vc).

Le temps de charge T1 à 63% du supercondensateur C1 (temps pour passer de 0% à 63% de Umax) est égal à :

$$T1 = R1*C1.$$

On utilise par exemple les valeurs suivantes pour R1 et C1 :
R1 = 1200$\Omega$ et C1 = 0,1F.

On a donc :
T1 = 120s = 2 minutes.

Le temps de charge à 95% est égal à 3*T1, et donc à 360s (ou 6 minutes).

Ainsi, suite à une première mise sous tension du compteur 1, le composant d'alimentation 8 charge le supercondensateur C1. Par « première mise sous tension », on désigne une mise sous tension quelconque survenant à un instant quelconque de la vie du compteur 1.

Lorsqu'une mise hors tension du compteur 1 survient (après la première mise sous tension), le composant d'alimentation 8 n'est plus alimenté.

Le circuit de maintien 25 permet d'éviter que le supercondensateur C1 ne se décharge et ce, tant que le couvre-borne 5 et le capot 6 demeurent fermés.

En effet, lorsque le composant d'alimentation 8 n'est pas alimenté, la tension sur la grille du deuxième transistor Q3 est nulle, et le deuxième transistor Q3 est donc dans un état bloqué. Les diodes internes des deux premiers transistors Q1, Q2 ne laissent pas passer le courant depuis le supercondensateur C1 vers l'entrée 29 du microcontrôleur 28 (ni dans le sens inverse), car elles sont montées tête-bêche. Le supercondensateur C1 ne se décharge donc pas vers la masse électrique 11 via le microcontrôleur 28.

La diode Schottky D1 sert quant à elle à éviter que le supercondensateur C1 ne se décharge hors tension via un chemin qui passerait par la résistance R1 et par le composant d'alimentation 8 vers la masse électrique 11.

Suite à la mise hors tension du compteur 1, si le couvre-borne 5 est ouvert et/ou si le capot 6 est ouvert, le premier interrupteur I1 passe dans un état fermé et/ou le deuxième interrupteur I2 passe dans un état fermé. Les deux armatures du supercondensateur C1 sont alors connectées l'une à l'autre via la résistance R2, et le supercondensateur C1 se décharge rapidement.

Le temps de décharge T2 à 37% du supercondensateur C1 (temps pour passer de 100% à 37% de Umax) est égal à :

$$T2 = R2*C2.$$

On utilise par exemple la valeur suivante pour R2 :
R2 = 10$\Omega$.

On a donc :
T2 = 1s.

Le temps de décharge à 95% est égal à 3*T2, et donc à 3s.

Il suffit donc que l'un des deux interrupteurs I1, I2 soit ne serait-ce que 3 secondes à l'état fermé pour décharger le supercondensateur C1.

Puis, suite à une deuxième mise sous tension du compteur 1, le microcontrôleur 28 acquiert un signal de détection représentatif d'une tension aux bornes du supercondensateur C1 et donc d'un niveau de charge du supercondensateur C1, et détecte, si le supercondensateur C1 est déchargé, que le couvre-borne 5 ou le capot 6 (ou bien les deux) a été ouvert suite à la mise hors tension du compteur 1.

Par « deuxième mise sous tension », on entend la mise sous tension qui suit la mise hors tension, et qui est donc la mise sous tension succédant directement à la première mise sous tension évoquée plus tôt.

Lorsque le compteur 1 est sous tension, la tension aux bornes du supercondensateur C1, lorsqu'il est chargé, est appliquée sur l'entrée 29 du microcontrôleur 28 via le circuit de maintien 25. Le signal de détection est donc ici la tension aux bornes du supercondensateur C1 elle-même (mais il pourrait s'agir d'un autre signal issu de cette tension).

En effet, lorsque le compteur 1 est sous tension et que le supercondensateur C1 est chargé, le composant d'alimentation 8 est lui aussi sous tension et produit la tension Vc égale à 3,3V sur sa sortie 14. Le deuxième transistor Q3 est donc dans un état passant, de sorte que les grilles des premiers transistors Q1, Q2 sont mises à la masse électrique 11 (via la résistance R4). Puisque le drain du premier transistor Q1 est au même potentiel que la deuxième borne 15 du supercondensateur C1 qui est chargé, les premiers transistors Q1, Q2 sont alors dans un état passant et la deuxième borne 15 du supercondensateur C1 est reliée à l'entrée 29 du microcontrôleur 28.

Lorsque le compteur 1 est sous tension et que le supercondensateur C1 est déchargé, les premiers transistors Q1, Q2 sont à l'état bloqué et la masse électrique 11 (via la résistance R5), est appliquée à l'entrée 29 du microcontrôleur 28.

En effet, lorsque le compteur 1 est sous tension et que le supercondensateur C1 est déchargé, bien que le deuxième transistor Q3 soit dans un état passant, et ainsi que les grilles des premiers transistors Q1, Q2 soient mises à la masse électrique 11, le drain du premier transistor Q1 étant polarisé à 0V, les premiers transistors Q1, Q2 sont à l'état bloqué, et la masse électrique 11 (via la résistance R5) est appliquée à l'entrée 29 du microcontrôleur 28.

Le microcontrôleur 28 compare alors la tension sur son entrée 29 avec un premier seuil prédéfini et un deuxième seuil prédéfini.

Le premier seuil prédéfini est ici égal à 1,8V et le deuxième seuil prédéfini est ici égal à 0,8V.

Si la tension sur l'entrée 29 est supérieure au premier seuil prédéfini, le microcontrôleur 28 lit un état « 1 » (état haut), ce qui correspond à un état de charge normal du supercondensateur C1 et donc à une absence de fraude.

Si la tension sur l'entrée 29 est inférieure au deuxième seuil prédéfini, le microcontrôleur 28 lit un état « 0 » (état bas), ce qui correspond à un état de charge insuffisant du supercondensateur C1. Le microcontrôleur 28 détecte que le couvre-borne 5 ou le capot 6 (ou bien les deux) a été ouvert suite à la mise hors tension du compteur 1, et donc détecte qu'une fraude a eu lieu.

Suite au redémarrage du compteur 1, le composant d'alimentation 8 va recharger le supercondensateur C1 (le circuit de charge a une constante de temps de 2 minutes). Par conséquent, la lecture doit être effectuée assez rapidement, par exemple dans un délai de quelques secondes après le redémarrage du compteur 1. En quelques secondes, la charge du supercondensateur C1 n'a pas le temps de changer significativement.

On évite ainsi d'avoir une différence de valeur significative de la charge du supercondensateur C1 entre la deuxième mise sous tension du compteur 1 et la lecture, et on évite de la sorte de lire un état haut alors que le couvre-borne 5 et/ou le capot 6 a été ouvert (« faux négatif »).

Si l'ouverture du couvre-borne 5 ou du capot 6 est détectée, le microcontrôleur 28 produit un message d'alarme et le transmet au SI en utilisant le modem CPL 32.

A chaque mise sous tension, le supercondensateur C1, même s'il a été déchargé suite à la mise hors tension précédente, mettra au maximum 6 minutes pour se recharger complètement (à 95%). Ceci implique que, même en cas de détection d'ouverture (auquel cas un message d'alarme est envoyé au SI), le supercondensateur C1 va ensuite se recharger et le dispositif de détection 7 est alors prêt à détecter toute nouvelle tentative de fraude survenant suite à une mise hors tension ultérieure.

On note que la résistance R5 tirée vers la masse 11 permet, lors de la lecture par le microcontrôleur 28 de la tension aux bornes du supercondensateur C1 et dans le cas où le supercondensateur C1 est déchargé, auquel cas les premiers transistors Q1, Q2 sont alors dans un état bloqué, d'appliquer une tension nulle sur l'entrée du microcontrôleur 28 qui lit donc un état 0.

On constate que, lorsque le compteur 1 est hors tension, aucun composant du circuit de détection 7 ne nécessite d'alimentation. En particulier, le circuit de maintien 25 ne nécessite aucune alimentation pour maintenir le supercondensateur C1 chargé, et l'énergie stockée par le supercondensateur C1 n'est pas utilisée pour alimenter des composants. De plus, le circuit de maintien 25 permet d'éviter que le supercondensateur C1 ne se décharge. Par conséquent, le supercondensateur C1 ne se décharge (presque) pas lorsque le compteur 1 est hors tension, de sorte que la détection de fraude est opérationnelle pendant une durée importante après une mise hors tension, et de sorte qu'il est possible de choisir un supercondensateur C1 avec une valeur de capacité relativement faible.

On vient de décrire une phase de détection qui est mise en oeuvre par le microcontrôleur 28 et qui consiste donc, suite à une deuxième mise sous tension du compteur 1 succédant à une première mise sous tension et à une mise hors tension, à lire un signal de détection représentatif de la tension aux bornes du supercondensateur C1 et, si le supercondensateur C1 est déchargé, à détecter que le couvre-borne 5 et/ou le capot 6 a été ouvert suite à ladite mise hors tension du compteur 1.

Il est préférable de ne pas tester le niveau de tension aux bornes du supercondensateur C1 à la mise sous tension initiale du compteur 1, qui est la mise sous tension du compteur 1 ayant lieu directement suite à son installation chez le client. Le supercondensateur C1 est en effet a priori déchargé lors de cette mise sous tension initiale, alors qu'aucune manoeuvre frauduleuse n'a encore pu avoir lieu.

Le compteur 1 utilise à cet effet un sémaphore, qui est une variable définie par un programme informatique implémenté dans le microcontrôleur 28.

A l'issue de la fabrication du compteur 1, c'est-à-dire en sortie d'usine, une première valeur prédéfinie a été conférée au sémaphore : S1 = 0.

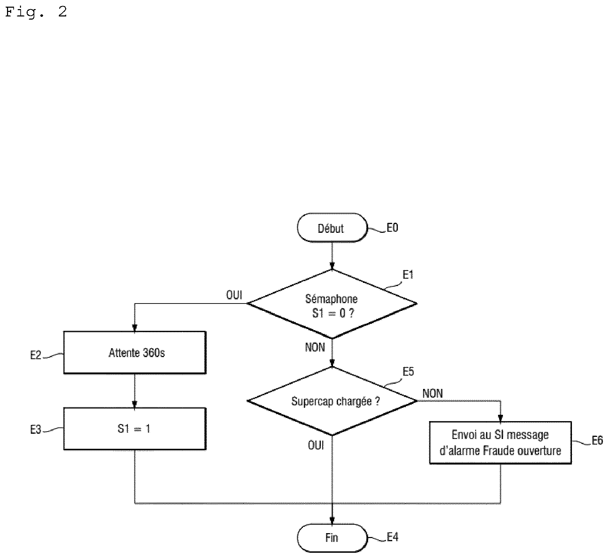

En référence à la figure 2, à chaque mise sous tension du compteur 1 (incluant la mise sous tension initiale), le microcontrôleur 28 met en oeuvre le procédé de détection suivant.

Le procédé de détection débute à l'étape E0. Le microcontrôleur 28 lit alors la valeur du sémaphore et vérifie si S1 = 0 (étape E1).

Si c'est le cas, le microcontrôleur 28 sait que la mise sous tension en question est la mise sous tension initiale.

Le microcontrôleur 28 ne met donc pas en oeuvre la détection de l'ouverture du couvre-borne 5 ou du capot 6, et ne teste donc pas s'il y a eu fraude, mais attend une durée prédéfinie D (étape E2).

La durée prédéfinie D correspond à un temps suffisant pour que la charge du supercondensateur C1 atteigne un niveau suffisant.

Le niveau suffisant est ici égal à 95%.

On a donc :

$$D = 3*T1 = 3*R1*C1 = 6 \text{ minutes.}$$

A l'issue de la durée prédéfinie D, le microcontrôleur 28 confère au sémaphore, de manière définitive, une deuxième valeur prédéfinie : S1 = 1 (étape E3). Le procédé de détection s'achève (étape E4).

A l'étape E1, si la valeur du sémaphore est égale à la deuxième valeur prédéfinie (c'est-à-dire si S1 = 1), le microcontrôleur 28 sait que la mise sous tension en question n'est pas la mise sous tension initiale. Le microcontrôleur 28 met alors en oeuvre la phase de détection et lit le signal de détection représentatif de la tension aux bornes du supercondensateur C1 (c'est-à-dire ici la tension aux bornes du supercondensateur C1 elle-même). Le microcontrôleur 28 vérifie donc si le supercondensateur C1 est chargé (étape E5) .

Si le supercondensateur C1 est toujours chargé, le procédé de détection s'achève (étape E4). Sinon, le microcontrôleur 28 produit et envoie au SI, via le modem CPL 32, un message d'alarme pour alerter d'une ouverture frauduleuse du couvre-borne 5 et/ou du capot 6. Le procédé de détection s'achève.

Bien entendu, l'invention n'est pas limitée au mode de réalisation décrit mais englobe toute variante entrant dans le champ de l'invention telle que définie par les revendications.

Les valeurs des composants utilisés pourraient bien sûr être différentes de celles présentées ici. De même, les temps de charge et de décharge du supercondensateur pourraient être différents.

Les composants utilisés pourraient être différents de ceux présentés ici.

Il est possible, dans le circuit de maintien, d'utiliser des transistors différents, et/ou de monter les transistors selon un agencement différent. Les premiers transistors pourraient être de type MOSFET canal N et le deuxième transistor de type MOSFET canal P. Les transistors ne sont pas nécessairement des MOSFETs. Le nombre de transistors utilisés pourrait être différent.

Le microcontrôleur qui lit la tension aux bornes du supercondensateur n'est pas nécessairement le microcontrôleur applicatif, mais pourrait par exemple être, dans une architecture à deux microcontrôleurs, le microcontrôleur métrologie. On note que, dans ce cas, le modem CPL est de préférence connecté au microcontrôleur applicatif.

Un autre composant pourrait être utilisé pour lire la tension aux bornes du supercondensateur. Il serait par exemple possible de relier une borne du supercondensateur à l'entrée d'un convertisseur analogique numérique (possiblement intégré dans le microcontrôleur). Cela permettrait, plutôt que de lire un signal de détection « binaire », présentant un état haut ou un état bas, de mesurer le niveau de la tension aux bornes du supercondensateur. Cette mesure peut par exemple être utilisée pour surveiller la charge maximale du supercondensateur et donc le vieillissement de celui-ci.

Le module de communication n'est pas nécessairement un modem CPL. Le message d'alarme peut être transmis par tout moyen de communication existant, filaire ou non. Une communication cellulaire, utilisant par exemple l'une des normes LTE-M ou NB-IoT, peut ainsi être mise en oeuvre.

Il est aussi possible d'utiliser plusieurs supercondensateurs, montés en parallèle par exemple.

## Revendications

**1.** Compteur électrique (1) comportant :

- un boîtier (4) comprenant au moins un élément de boîtier (5, 6), qui est normalement fermé en opération mais qui est susceptible d'être ouvert ;
- un supercondensateur (C1) ;
- un circuit d'alimentation (8) agencé pour, suite à une première mise sous tension du compteur électrique, charger le supercondensateur ;
- un circuit de maintien (25) agencé pour, suite à une mise hors tension du compteur électrique qui survient après ladite première mise sous tension, éviter que le supercondensateur ne se décharge tant que l'élément de boîtier demeure fermé ;

- un circuit de décharge (16) agencé pour, suite à ladite mise hors tension du compteur électrique, décharger le supercondensateur si l'élément de boîtier est ouvert ; et
- un circuit de traitement (27) agencé pour, suite à une deuxième mise sous tension du compteur électrique qui survient après ladite mise hors tension, acquérir un signal de détection représentatif d'une tension aux bornes du supercondensateur et donc d'un niveau de charge du supercondensateur, et détecter, si le supercondensateur est déchargé, que l'élément de boîtier a été ouvert suite à ladite mise hors tension du compteur électrique (1),

**caractérisé en ce que** :

le circuit de maintien comporte deux premiers transistors (Q1, Q2) et un deuxième transistor (Q3), les deux premiers transistors étant montés tête-bêche, l'un des premiers transistors (Q1) ayant une borne reliée à une borne (15) du supercondensateur et l'autre des premiers transistors (Q2) ayant une borne reliée à une entrée (29) du circuit de traitement, le deuxième transistor étant agencé pour mettre les premiers transistors dans un état passant lorsque le compteur électrique est sous tension et que le supercondensateur (C1) est chargé.

2. Compteur électrique selon la revendication 1, dans lequel le circuit de décharge (16) comprend au moins un interrupteur (I1, I2) monté en parallèle avec le supercondensateur (C1), l'interrupteur étant agencé pour coopérer avec l'élément de boîtier de sorte que, lorsque l'élément de boîtier est fermé, l'interrupteur est ouvert et de sorte que, lorsque l'élément de boîtier est ouvert, l'interrupteur est fermé et provoque une décharge du supercondensateur (C1).

3. Compteur électrique selon la revendication 2, dans lequel le compteur électrique comporte deux éléments de boîtier qui comprennent un couvre-borne (5) et un capot (6), le circuit de décharge comprenant un premier interrupteur (I1) agencé pour coopérer avec le couvre-borne (5) et un deuxième interrupteur (I2) agencé pour coopérer avec le capot (6), le premier interrupteur (I1) et le deuxième interrupteur (I2) étant tous deux montés en parallèle l'un avec l'autre et avec le supercondensateur (C1).

4. Compteur électrique selon l'une des revendications précédentes, dans lequel le circuit de traitement (27) est relié au circuit de maintien (25), dans lequel le circuit de maintien (25) est relié à ladite borne (15) du supercondensateur (C1) et présente un état bloqué lorsque le compteur électrique (1) est hors tension et un état passant lorsque le compteur électrique (1) est sous tension, le circuit de traitement (27) et le circuit de maintien (25) étant agencés de sorte que, lorsque le compteur électrique (1) est sous tension, la tension aux bornes du supercondensateur est appliquée sur ladite entrée (29) du circuit de traitement (27) via le circuit de maintien (25) lorsque le supercondensateur (C1) est chargé, et une tension de 0V est appliquée sur ladite entrée (29) lorsque ledit supercondensateur (C1) est déchargé.

5. Compteur électrique selon la revendication 1, dans lequel les premiers transistors (Q1, Q2) sont des transistors de type MOSFET canal P et le deuxième transistor (Q3) est un transistor de type MOSFET canal N, une grille du deuxième transistor étant reliée au circuit d'alimentation, une source du deuxième transistor étant reliée à une masse électrique (11), et un drain du deuxième transistor étant relié aux grilles des premiers transistors (Q1, Q2).

6. Procédé de détection, mis en oeuvre dans le circuit de traitement (27) d'un compteur électrique (1) selon l'une des revendications précédentes, et comportant une phase de détection comprenant les étapes, suite à la deuxième mise sous tension du compteur électrique (1) qui survient après ladite mise hors tension, d'acquérir le signal de détection représentatif de la tension aux bornes du supercondensateur et donc d'un niveau de charge du supercondensateur, et de détecter, si le supercondensateur est déchargé, que l'élément de boîtier a été ouvert suite à ladite mise hors tension du compteur électrique (1).

7. Procédé de détection selon la revendication 6, dans lequel un sémaphore est défini par un programme informatique implémenté dans le circuit de traitement (27), le sémaphore ayant, à l'issue de la fabrication du compteur électrique (1), une première valeur prédéfinie, le procédé de détection comprenant en outre les étapes, mises en oeuvre à chaque mise sous tension du compteur électrique, de :

- lire une valeur du sémaphore, et :

- si la valeur du sémaphore est égale à la première valeur prédéfinie, attendre une durée prédéfinie, puis conférer au sémaphore, de manière définitive, une deuxième valeur prédéfinie ;
- si la valeur du sémaphore est égale à la deuxième valeur prédéfinie, mettre en oeuvre la phase de détection.

8. Procédé de détection selon l'une des revendications 6 à 7, comprenant en outre les étapes, si le circuit de traitement (27) a détecté que l'élément de boîtier été ouvert suite à la mise hors tension du compteur électrique, de générer et d'envoyer un message d'alarme.

9. Programme d'ordinateur comprenant des instructions qui conduisent le circuit de traitement (27) du compteur électrique (1) selon l'une des revendications 1 à 5 à exécuter les étapes du procédé de détection selon l'une des revendications 6 à 8.

10. Support d'enregistrement lisible par ordinateur, sur lequel est enregistré le programme d'ordinateur selon la revendication 9.


**Patentansprüche**

1. Stromzähler (1), umfassend:

   - ein Gehäuse (4), das mindestens ein Gehäuseelement (5, 6) umfasst, das im Betrieb üblicherweise geschlossen ist, aber geöffnet werden kann;
   - einen Superkondensator (C1);
   - eine Versorgungsschaltung (8), die ausgebildet ist, nach einem ersten Einschalten des Stromzählers den Superkondensator zu laden;
   - eine Halteschaltung (25), die ausgebildet ist, nach einem Abschalten des Stromzählers, das nach dem genannten ersten Einschalten erfolgt, zu verhindern, dass sich der Superkondensator entlädt, solange das Gehäuseelement geschlossen bleibt;
   - eine Entladungsschaltung (16), die ausgebildet ist, nach dem genannten Abschalten des Stromzählers den Superkondensator zu entladen, wenn das Gehäuseelement geöffnet ist; und
   - eine Verarbeitungsschaltung (27), die ausgebildet ist, nach einem zweiten Einschalten des Stromzählers, das nach dem genannten Abschalten erfolgt, ein Detektionssignal zu erfassen, das repräsentativ für eine Spannung an den Klemmen des Superkondensators ist und folglich für ein Ladungsniveau des Superkondensators, und zu detektieren, wenn der Superkondensator entladen ist, ob das Gehäuseelement nach dem genannten Abschalten des Stromzählers (1) geöffnet wurde, **dadurch gekennzeichnet, dass**:
   die Halteschaltung zwei erste Transistoren (Q1, Q2) und einen zweiten Transistor (Q3) umfasst, wobei die beiden ersten Transistoren entgegengesetzt angeschlossen sind, wobei einer der ersten Transistoren (Q1) eine Klemme hat, die mit einer Klemme (15) des Superkondensators verbunden ist, und der andere der ersten Transistoren (Q2) eine Klemme hat, die mit einem Eingang (29) der Verarbeitungsschaltung verbunden ist, wobei der zweite Transistor ausgebildet ist, die ersten Transistoren in einen Durchlasszustand zu bringen, wenn der Stromzähler unter Spannung steht und wenn der Superkondensator (C1) geladen ist.

2. Stromzähler nach Anspruch 1, bei dem die Entladungsschaltung (16) mindestens einen Unterbrecher (I1, I2) umfasst, der parallel zum Superkondensator (C1) geschaltet ist, wobei der Unterbrecher ausgebildet ist, mit dem Gehäuseelement derart zusammenzuwirken, dass, wenn das Gehäuseelement geschlossen ist, der Unterbrecher geöffnet ist, und derart, dass, wenn das Gehäuseelement geöffnet ist, der Unterbrecher geschlossen ist und eine Entladung des Superkondensators (C1) verursacht.

3. Stromzähler nach Anspruch 2, bei dem der Stromzähler zwei Gehäuseelemente umfasst, die einen Klemmendeckel (5) und eine Abdeckung (6) umfassen, wobei die Entladungsschaltung einen ersten Unterbrecher (I1) umfasst, der ausgebildet ist, mit dem Klemmendeckel (5) zusammenzuwirken, und einen zweiten Unterbrecher (12), der ausgebildet ist, mit der Abdeckung (6) zusammenzuwirken, wobei der erste Unterbrecher (I1) und der zweite Unterbrecher (12) alle beide parallel zueinander und zu dem Superkondensator (C1) geschaltet sind.

4. Stromzähler nach einem der vorhergehenden Ansprüche, bei dem die Verarbeitungsschaltung (27) mit der Halteschaltung (25) verbunden ist, bei dem die Halteschaltung (25) mit der genannten Klemme (15) des Superkondensators (C1) verbunden ist und einen blockierten Zustand aufweist, wenn der Stromzähler (1) ohne Spannung ist, und einen Durchlasszustand, wenn der Stromzähler (1) unter Spannung ist, wobei die Verarbeitungsschaltung (27) und die Halteschaltung (25) so ausgebildet sind, dass, wenn der Stromzähler (1) unter Spannung ist, die Spannung an den Klemmen des Superkondensators an dem genannten Eingang (29) der Verarbeitungsschaltung (27) über die Halteschaltung (25) angelegt wird, wenn der Superkondensator (C1) geladen ist, und eine Spannung von 0V an dem genannten Eingang (29) angelegt wird, wenn der genannte Superkondensator (C1) entladen ist.

**5.** Stromzähler nach Anspruch 1, bei dem die ersten Transistoren (Q1, Q2) Transistoren vom Typ P-Kanal MOSFET sind und der zweite Transistor (Q3) ein Transistor vom Typ N-Kanal MOSFET ist, wobei ein Gate des zweiten Transistors mit der Versorgungsschaltung verbunden ist, wobei eine Source des zweiten Transistors mit einer elektrischen Masse (11) verbunden ist, und ein Drain des zweiten Transistors mit den Gates der ersten Transistoren (Q1, Q2) verbunden ist.

**6.** Detektionsverfahren, das in der Verbindungsschaltung (27) eines Stromzählers (1) nach einem der vorhergehenden Ansprüche durchgeführt wird und eine Detektionsphase umfasst, die nach dem zweiten Einschalten des Stromzählers (1), das nach dem genannten Abschalten erfolgt, die Schritte umfasst: Erfassen des Detektionssignals, das repräsentativ für die Spannung an den Klemmen des Superkondensators und folglich für ein Ladungsniveau des Superkondensators ist, und Detektieren, wenn der Superkondensator entladen ist, ob das Gehäuseelement nach dem genannten Abschalten des Stromzählers (1) geöffnet wurde.

**7.** Detektionsverfahren nach Anspruch 6, bei dem ein Semaphor von einem Computerprogramm definiert ist, das in der Verarbeitungsschaltung (27) implementiert wird, wobei das Semaphor zu Beginn der Herstellung des Stromzählers (1) einen ersten vordefinierten Wert hat, wobei das Detektionsverfahren ferner die Schritte umfasst, die bei jedem Einschalten des Stromzählers durchgeführt werden:

- Lesen eines Werts des Semaphors, und:

- wenn der Wert des Semaphors gleich dem ersten vordefinierten Wert ist, Abwarten für eine vordefinierte Dauer und dann Zuweisen eines vordefinierten zweiten Werts an das Semaphor auf endgültige Weise;
- wenn der Wert des Semaphors gleich dem zweiten vordefinierten Wert ist, Durchführen der Detektionsphase.

**8.** Detektionsverfahren nach einem der Ansprüche 6 bis 7, ferner umfassend, wenn die Verarbeitungsschaltung (27) erfasst hat, dass das Gehäuseelement nach dem Abschalten des Stromzählers geöffnet ist, die Schritte des Erzeugens und Aussendens einer Alarmnachricht.

**9.** Computerprogramm, umfassend Anweisungen, die die Verarbeitungsschaltung (27) des Stromzählers (1) nach einem der Ansprüche 1 bis 5 dazu veranlassen, die Schritte des Detektionsverfahrens nach einem der Ansprüche 6 bis 8 auszuführen.

**10.** Computerlesbarer Aufzeichnungsträger, auf dem das Computerprogramm nach Anspruch 9 gespeichert ist.

**Claims**

**1.** An electricity meter (1) comprising:

· a housing (4) including at least one housing element (5, 6) that is normally closed in operation, but that is capable of being opened;
· a supercapacitor (C1);
· a power supply circuit (8) arranged to act, whenever the electricity meter is put into connection with electric power, to charge the supercapacitor;
· a charge-maintaining circuit (25) arranged, to act whenever the electricity meter is taken out of connection with electric power after previously being in connection with electric power, to prevent the supercapacitor from discharging so long as the housing element remains closed;
· a discharge circuit (16) arranged to act, whenever said electricity meter has been taken out of connection with electric power, to discharge the supercapacitor in the event that the housing element is opened; and
· a processor circuit (27) arranged to act, whenever the electricity meter is put back into connection with electric power after being taken out of connection with electric power, to acquire a detection signal representative of the voltage across the terminals of the supercapacitor and thus representative of the level of charge of the supercapacitor, and if the supercapacitor is discharged, to detect that the housing element has been opened since the electricity meter (1) was taken out of connection with electric power;

**characterized in that** the charge-maintaining circuit comprising two first transistors (Q1, Q2) and a second transistor (Q3), the two first transistors being connected back-to-back, one of the first transistors (Q1) having a terminal connected to a terminal (15) of the supercapacitor and the other first transistor (Q2) having a terminal connected to an input (29) of the processor circuit, the second transistor being arranged to put the first transistors into a conductive state when the electricity meter is electrically powered and the supercapacitor (C1) is charged.

2. An electricity meter according to claim 1, wherein the discharge circuit (16) comprises at least one switch (I1, I2) connected in parallel with the supercapacitor (C1), the switch being arranged to co-operate with the housing element in such a manner that, while the housing element is closed, the switch is open, and in such a manner that, while the housing element is open, the switch is closed and causes the supercapacitor (C1) to discharge.

3. An electricity meter according to claim 2, wherein the electricity meter includes two housing elements comprising a terminal-cover (5) and a hood (6), the discharge circuit having a first switch (I1) arranged to co-operate with the terminal-cover (5) and a second switch (I2) arranged to co-operate with the hood (6), the first and second switches (I1, I2) being connected in parallel both with each other and with the supercapacitor (C1) .

4. An electricity meter according to any preceding claim, wherein the processor circuit (27) is connected to the charge-maintaining circuit (25), wherein the charge-maintaining circuit (25) is connected to said terminal (15) of the supercapacitor (C1) and presents a nonconductive state when the electricity meter (1) is not electrically powered and a conductive state when the electricity meter (1) is electrically powered, the processor circuit (27) and the charge-maintaining circuit (25) being arranged in such a manner that, while the electricity meter (1) is electrically powered, the voltage across the terminals of the supercapacitor is applied to said input (29) of the processor circuit (27) via the charge-maintaining circuit (25) when the supercapacitor (C1) is charged, and a voltage of 0 V is applied to said input (29) when said supercapacitor (C1) is discharged.

5. An electricity meter according to claim 1, wherein the first transistors (Q1, Q2) are P channel MOSFET type transistors and the second transistor (Q3) is an N channel MOSFET type transistor, a grid of the second transistor being connected to the power supply circuit, a source of the second transistor being connected to electrical ground (11), and a drain of the second transistor be connected to the grids of the first transistors (Q1, Q2).

6. A detection method performed in the processor component (27) of an electricity meter (1) according to any preceding claim, and including a detection stage comprising steps that are performed whenever the electricity meter (1) is put back into connection with electric power after being taken out of connection with electric power, said steps comprising acquiring a detection signal representative of the voltage across the terminals of the supercapacitor and thus representative of a level of charge of the supercapacitor, and in the event that the supercapacitor is discharged, of detecting that the housing element has been opened since the electricity meter (1) was taken out of connection with electric power.

7. A detection method according to claim 6, wherein a semaphore is defined by a computer program executed in the processor circuit (27), the semaphore having a first predefined value at the end of manufacturing the electricity meter (1), the detection method further comprising the steps that are performed each time the electricity meter is put into connection with electric power, said steps comprising:

· reading the value of the semaphore; and:

· if the value of the semaphore is equal to the first predefined value, waiting for a predefined duration, and then giving in definitive manner a second predefined value to the semaphore;
· if the value of the semaphore is equal to the second predefined value, performing the detection stage.

8. A detection method according to claim 6 or claim 7, further comprising the steps, in the event that the processor circuit (27) has detected that the housing element has been opened since the electricity meter was taken out of connection with electric power, of generating and sending an alarm message.

9. A computer program including instructions that cause the processor component (27) of the electricity meter (1) according to any one of claims 1 to 5 to execute the steps of the detection method according to any one of claims 6 to 8.

10. A computer-readable storage medium storing the computer program according to claim 9.

Fig. 1

Fig. 2

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- CN 202119820 U
- US 2021305829 A1

- US 2013119974 A1